# EUROPEAN PATENT SPECIFICATION

(11) **EP 3 832 744 B1**
(45) Date of publication and mention of the grant of the patent: **07.09.2022**
(21) Application number: 20187678.6
(22) Date of filing: 24.07.2020
(51) Int. Cl.: H01L 51/00, H01L 21/02, H01L 21/768

(54) **METHOD OF MANUFACTURING STRUCTURES ON SUBSTRATES USING WET DEPOSITION**
VERFAHREN ZUR HERSTELLUNG VON STRUKTUREN AUF SUBSTRATEN MITTELS NASSABSCHEIDUNG
PROCÉDÉ DE FABRICATION DE STRUCTURES SUR DES SUBSTRATS PAR DÉPÔT HUMIDE

(30) Priority: 02.12.2019 EP 19212932
(43) Date of publication of application: 09.06.2021
(73) Proprietor: Plastic Logic HK Limited, Central Hong Kong (HK)
(72) Inventor: RUCKMICH, Stefan, 01099 Dresden (DE); NEUMANN, Karsten, 02994 Bernsdorf (DE)
(74) Representative: Lippert Stachow Patentanwälte Rechtsanwälte Partnerschaft mbB

(56) References cited:
- US-A1- 2006 292 851

## Description

The invention relates generally to the production of structures on substrates by wet deposition. It enables the use of wet deposition in that it avoids short circuits between electrically conductive layers to achieve an acceptable yield and reliability even if relatively large particles or unevenness are present on a substrate.

In particular, the invention relates to manufacturing of so-called backplanes or of structures on such backplanes, in particular for manufacturing of FPDs (Flat Panel Displays).

More particularly, the invention relates to depositing a first dielectric layer on a substrate by wet deposition, whereas a first electrically conductive layer is deposited on the first dielectric layer, a second dielectric layer is deposited on it by wet deposition, and a second electrically conductive layer is deposited on it.

The use of backplanes is well known in the production of FPDs. A backplane consists of an array of pixels forming an active matrix. Each pixel is composed by a storage capacitor and at least one field-effect transistor FET, which can be formed indistinctly by organic or inorganic semiconductor and dielectric materials. The FET-based active-matrix backplane can be processed on a flexible substrate.

The use of backplanes is well known in the production of EPDs (Electronic Paper Displays), OLEDs (Organic Light Emitting Displays), LCDs (Liquid Crystal Displays) or other printed circuits.

To manufacture such products, product-specific structures are applied onto the backplane. In principle, printing or structured coating can be used. These are processes that work from the wet phase, i.e. use liquid material for structuring, e.g. inkjet printing or spinning. US 2006/292851 A1 discloses an interlayer dielectric stack deposited by spincoating.

Wet-structuring processes can be realized at low cost and with sufficient accuracy.

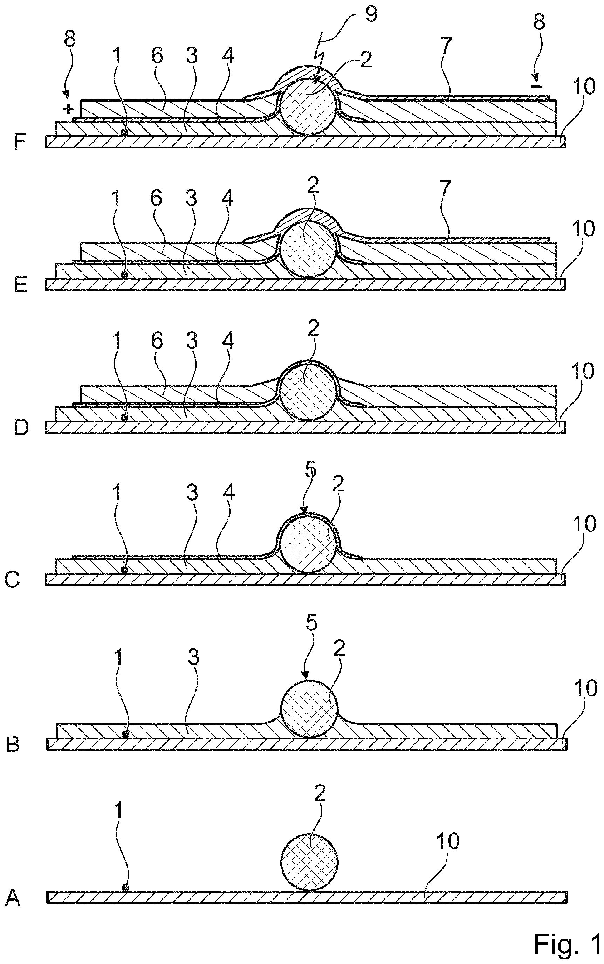

The advantages and disadvantages of use are explained below with reference to Fig. 1

An advantage of wet deposition processes is that these layers can level out small topographies. Small particles 1 can be fully covered as shown on the left side of Fig. 1. The disadvantage is that particles 2 larger than the thickness of the layer 3 after subsequent drying of the deposited wet film stick out of that layer as shown in the middle of Fig. 1B. This is because the liquid coating material of the layer 3 flows off the larger particle 2 before drying and/or the coating material shrinks during drying, thereby losing thickness and releasing particle 2. Usually the layer 3 is deposited as a first dielectric layer 3 by such a wet deposition process. On the first dielectric layer 3 a first electrically conductive layer 4 is deposited, typically by a sputter processes. Such a first electrically conductive layer 4 covers conformally the surface topography i.e. both the surface of the first dielectric layer 3 and the uncovered exposed surface 5 of the larger particle 2, as shown in Fig. 1C.

A second dielectric layer 6, also deposited by wet processes is deposited. Here the same problem exists as described above, that also the second dielectric layer cannot cover the large particle or the unevenness caused by this particle, as shown in Fig. 1D. This causes the first electrically conductive layer 4 on top of the large particle 2 to be uncovered and exposed.

If a second electrically conductive layer 7 is now deposited to produce a specific function, usually again by a sputtering process, this second electrically conductive layer 7 contacts the first electrically conductive layer 4, as shown in Fig. 1E.

If an electrical voltage 8 is now applied between the first electrically conductive layer 4 and the second electrically conductive layer 7, as shown in Fig. 1E, a short circuit 9 results. The structure on the substrate 10 is unusable. If the substrate 10 is the base of a backplane, the entire backplane may be damaged. If the substrate itself is a backplane, the layer sequence applied in this way can lead to a loss of the FPD.

Since the occurrence of large particles 2 cannot be excluded and the use of wet deposition causes the problems described above, the use of wet deposition is not economically reasonable.

For this reason it is the objective of the invention, to enable the use of wet deposition in that it avoids short circuits between electrically conductive layers to achieve an acceptable yield and reliability even if relatively large particles or unevenness are present on a substrate.

The objective of the invention is solved by a method of manufacturing structures on substrates using wet deposition wherein a first dielectric layer is deposited on a substrate by wet deposition. A first electrically conductive layer is deposited on the first dielectric layer and a second dielectric layer is deposited on it by wet deposition. Thereon a second electrically conductive layer is deposited. The inventive step in this method is that a dielectric interlayer is deposited between the first dielectric layer and the second electrically conductive layer by a dry deposition process.

The interlayer may be deposited by a CVD-process, a PVD-process or a PVPD-process. Other dry deposition processes are also possible if the condition is met that the interlayer has to be conformally coated (i.e. the interlayer will cover the entire surface) and should be pinhole free.

The invention can be used in many ways.

An embodiment of the invention provides that the layers are deposited on a substrate for manufacturing of a backplane,

In another embodiment the layers may be deposited on a backplane for manufacturing of a FDP (Flat Panel Display. Another embodiment of the invention provides that the layers may be deposited for manufacturing of EPDs (Electronic Paper Displays), OLEDs (Organic Light Emitting Displays) or LCDs (Liquid Crystal Displays).

In another embodiment the interlayer is consisting of Parylene for example Parylene-C. However, Parylene-N or Parylene-F is also possible. In the following, therefore, generally only Parylene will be mentioned.. Therefore the interlayer may be deposited as Parylene by a PVPD process. In a standard FPD-manufactoring environment this PVPD process is not available. Here the Parylene process may be replaced by a PVD or CVD process as above mentioned. Therefore an embodiment of the invention provides that the interlayer may be deposited as silicon nitride and another embodiment of the invention provides that the interlayer may be deposited as silicon oxide. In any case the interlayer has to be conformally coated and should be pinhole free.

The invention shall be described in more detail by means of an example. In the associated drawings show
- Fig. 1: the problem with a possible use of wet separation as described in the beginning of this description,
- Fig. 2: an inventive arrangement of an interlayer arranged above the first conductive layer compared to a non-inventive arrangement (upper part of the drawing) for a large particle,
- Fig. 3: an inventive arrangement of an interlayer arranged below the second conductive layer compared to a non-inventive arrangement(upper part of the drawing) for a large particle and
- Fig. 4: an inventive arrangement of an interlayer arranged below the second conductive layer compared to a non-inventive arrangement (upper part of the drawing) for an electrically conductive particle.

The main feature of the invention is the introduction of a dielectric interlayer 11.

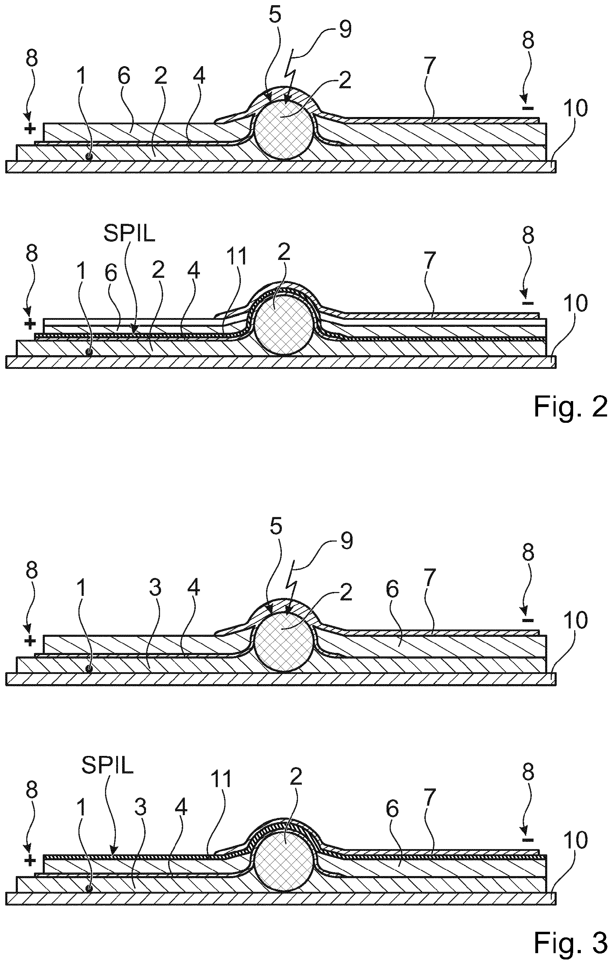

The interlayer 11 (specially marked in Figs. 2 to 4 as "SPIL" = Short Protection InterLayer) avoids the direct contact between the first electrically conductive layer 4 and the second electrically conductive layer 7 and enhances thereby the yield of the production and the reliability of the product.

In difference to wet deposited dielectric layers 3 and 6, this interlayer 11 has to be conformally deposited. That means that the interlayer 11 covers the topography with a uniform thickness. Typically the materials of the interlayer 11 are deposited by PVD or CVD processes.

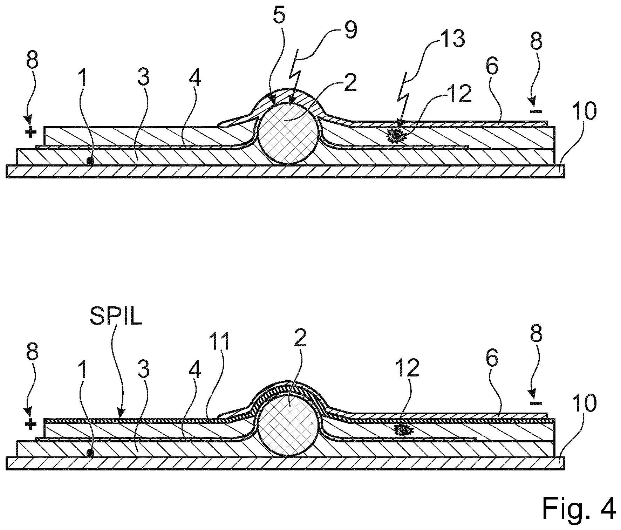

Generally, the interlayer 11 is processed between the first dielectric layer 3 and the second electrically conductive layer 7 by a dry deposition process. As shown in Fig. 2 the interlayer 11 can be arranged directly above the lower first electrically conductive layer 4. Another possibility is shown in Fig. 3 and Fig. 4 where the interlayer 11 is arranged directly below the upper conductive layer 7.

If the interlayer 11 is processed directly below
the upper second electrically conductive layer conductive layer 7, an electrical conductive particle 12, also able to cause a short circuit 13, can be effectively isolated to avoid shorting.

The shorts protecting interlayer (SPIL) 11 can be used to improve the yield and the reliability of oTFT-backplanes and other electronic products that are mainly fabricated be wet coating processes. In this example the interlayer 11 may be consisting of Parylene deposited by a PVPD process.

Parylene belongs to a group of inert, hydrophobic, optically transparent, polymeric coating materials with a wide range of industrial applications. The coating is applied to the substrate in a vacuum by resublimation from the gas phase as a pore-free and transparent polymer film.

But other dielectric materials deposited by other processes are suitable if the condition is fulfilled, that the interlayer 11 will be both conformally coated and pinhole free.

### Method of manufacturing structures on substrates using wet deposition

### Reference numbers

- 1: small particle
- 2: large particle
- 3: layer, first dielectric layer
- 4: first electrically conductive layer
- 5: exposed surface
- 6: second dielectric layer
- 7: second electrically conductive layer
- 8: voltage
- 9: short circuit
- 10: substrate
- 11: interlayer
- 12: electrical conductive particle
- 13: short circuit

## Claims

1. Method of manufacturing structures on substrates using wet deposition wherein a first dielectric layer (3) is deposited on a substrate (10) by wet deposition, a first electrically conductive layer (4) is deposited on the first dielectric layer (3), a second dielectric layer (6) is deposited on it by wet deposition, and a second electrically conductive layer (7) is deposited on it, **characterized in that** an dielectric interlayer (11) is deposited between the first dielectric layer (3) and the second electrically conductive layer (7) by a dry deposition process.

2. Method according claim 1, **characterized in that** the interlayer (11) is deposited by a CVD-process.

3. Method according claim 1, **characterized in that** the interlayer (11) is deposited by a PVD-process.

4. Method according claim 1, **characterized in that** the interlayer (11) is deposited by a PVPD-process.

5. Method according to one of the claims 1 to 4, **characterized in that** the layers (3; 4; 6; 11) are deposited on a substrate (10) for manufacturing of a backplane.

6. Method according to one of the claims 1 to 4, **characterized in that** the layers (3; 4; 6; 11) are deposited on a backplane as the substrate (10).

7. Method according to claim 6, **characterized in that** the layers are deposited for manufacturing of a FDP (Flat Panel Display).

8. Method according to claim 7, **characterized in that** the layers (3; 4; 6; 11) are deposited for manufacturing of EPDs (Electronic Paper Displays), OLEDs (Organic Light Emitting Displays) or LCDs (Liquid Crystal Displays).

9. Method according to one of the claims 1 to 8, **characterized in that** the interlayer (11) is consisting of Parylene.

10. Method according to one of the claims 1 to 9, **characterized in that** the interlayer is deposited as silicon nitride.

11. Method according to one of the claims 1 to 9, **characterized in that** the interlayer is deposited as silicon oxide.

## Patentansprüche

1. Verfahren zur Herstellung von Strukturen auf Substraten mittels Nassabscheidung, wobei eine erste dielektrische Schicht (3) durch Nassabscheidung auf einem Substrat (10) abgeschieden wird, eine erste elektrisch leitfähige Schicht (4) auf der ersten dielektrischen Schicht (3) abgeschieden wird, eine zweite dielektrische Schicht (6) darauf durch Nassabscheidung abgeschieden wird, und eine zweite elektrisch leitfähige Schicht (7) darauf abgeschieden wird, **dadurch gekennzeichnet, dass** eine dielektrische Zwischenschicht (11) zwischen der ersten dielektrischen Schicht (3) und der zweiten elektrisch leitfähigen Schicht (7) durch einen Trockenabscheideprozess abgeschieden wird.

2. Verfahren nach Anspruch 1, **dadurch gekennzeichnet, dass** die Zwischenschicht (11) durch einen CVD-Prozess abgeschieden wird.

3. Verfahren nach Anspruch 1, **dadurch gekennzeichnet, dass** die Zwischenschicht (11) durch einen PVD-Prozess abgeschieden wird.

4. Verfahren nach Anspruch 1, **dadurch gekennzeichnet, dass** die Zwischenschicht (11) durch einen PVPD-Prozess abgeschieden wird.

5. Verfahren nach einem der Ansprüche 1 bis 4, **dadurch gekennzeichnet, dass** die Schichten (3; 4; 6; 11) auf einem Substrat (10) zur Herstellung einer Rückwandplatine (Backplane) abgeschieden werden.

6. Verfahren nach einem der Ansprüche 1 bis 4, **dadurch gekennzeichnet, dass** die Schichten (3; 4; 6; 11) auf einer Backplane als Substrat (10) abgeschieden werden.

7. Verfahren nach Anspruch 6, **dadurch gekennzeichnet, dass** die Schichten zur Herstellung einer FDP (Flachbildschirmanzeige) abgeschieden werden.

8. Verfahren nach Anspruch 7, **dadurch gekennzeichnet, dass** die Schichten (3; 4; 6; 11) zur Herstellung von EPDs (elektronischen Papieranzeigen), OLEDs (organischen Licht emittierenden Anzeigen) oder LCDs (Flüssigkristallanzeigen) abgeschieden werden.

9. Verfahren nach einem der Ansprüche 1 bis 8, **dadurch gekennzeichnet, dass** die Zwischenschicht (11) aus Parylen besteht.

10. Verfahren nach einem der Ansprüche 1 bis 9, **dadurch gekennzeichnet, dass** die Zwischenschicht als Siliciumnitrid abgeschieden wird.

11. Verfahren nach einem der Ansprüche 1 bis 9, **dadurch gekennzeichnet, dass** die Zwischenschicht als Siliciumoxid abgeschieden wird.

## Revendications

1. Procédé de fabrication de structures sur des substrats au moyen d'un dépôt par voie humide dans lequel une première couche diélectrique (3) est déposée sur un substrat (10) par dépôt par voie humide, une première couche électriquement conductrice (4) est déposée sur la première couche diélectrique (3), une deuxième couche diélectrique (6) est déposée sur elle par dépôt par voie humide, et une deuxième couche électriquement conductrice (7) est déposée sur elle, **caractérisé en ce qu'**une couche intercalaire diélectrique (11) est déposée entre la première couche diélectrique (3) et la deuxième couche électriquement conductrice (7) par une opération de dépôt par voie sèche.

2. Procédé selon la revendication 1, **caractérisé en ce que** la couche intercalaire (11) est déposée par une opération de CVD.

3. Procédé selon la revendication 1, **caractérisé en ce que** la couche intercalaire (11) est déposée par une opération de PVD.

4. Procédé selon la revendication 1, **caractérisé en ce que** la couche intercalaire (11) est déposée par une opération de PVPD.

5. Procédé selon une des revendications 1 à 4, **caractérisé en ce que** les couches (3 ; 4 ; 6 ; 11) sont déposées sur un substrat (10) pour la fabrication d'un fond de panier.

6. Procédé selon une des revendications 1 à 4, **caractérisé en ce que** les couches (3 ; 4 ; 6 ; 11) sont déposées sur un fond de panier servant de substrat (10).

7. Procédé selon la revendication 6, **caractérisé en ce que** les couches sont déposées pour la fabrication d'un FDP (écran plat).

8. Procédé selon la revendication 7, **caractérisé en ce que** les couches (3 ; 4 ; 6 ; 11) sont déposées pour la fabrication d'EPD (écrans de papier électronique), d'OLED (écrans électroluminescents organiques) ou de LCD (écrans à cristaux liquides).

9. Procédé selon une des revendications 1 à 8, **caractérisé en ce que** la couche intercalaire (11) consiste en du parylène.

10. Procédé selon une des revendications 1 à 9, **caractérisé en ce que** la couche intercalaire est déposée sous forme de nitrure de silicium.

11. Procédé selon une des revendications 1 à 9, **caractérisé en ce que** la couche intercalaire est déposée sous forme d'oxyde de silicium.
